# EUROPÄISCHE PATENTSCHRIFT

(11) **EP 0 482 010 B1**
(45) Veröffentlichungstag und Bekanntmachung des Hinweises auf die Patenterteilung: **09.03.1994**
(21) Anmeldenummer: 90909044.1
(22) Anmeldetag: 15.06.1990
(51) Int. Cl.: G01R 33/54

(54) **VERFAHREN ZUR ERSTELLUNG EINER IMPULSSEQUENZ**
PROCESS FOR GENERATING A PULSE SEQUENCE
PROCEDE POUR L'ETABLISSEMENT D'UNE SEQUENCE D'IMPULSIONS

(30) Priorität: 27.06.1989 DE 3920997
(43) Veröffentlichungstag der Anmeldung: 29.04.1992
(73) Patentinhaber: BRUKER Analytische Messtechnik GmbH, 76287 Rheinstetten (DE)
(72) Erfinder: KASTEN, Arne, D-7500 Karlsruhe 1 (DE); LAUKIEN, Günther, D-7512 Rheinstetten 4 (DE)
(74) Vertreter: KOHLER SCHMID + PARTNER
(86) Internationale Anmeldenummer: DE9000457
(87) Internationale Veröffentlichungsnummer: WO9100530

(56) Entgegenhaltungen:
- EP-A- 0 195 670
- EP-A- 0 287 661
- WO-A-85/02264
- IEEE Transactions on Biomedical Engineering Band BME-34, Nr. 12, Dezember 1987, IEEE, (New York, NY, US), D. Foxvog et al.: "PUPA: A pulse programming assistant for NMR imaging", Seiten 938-942, siehe Abschnitte: "System Architecture" und "System Operation"; Abbildungen 1-4
- IEEE Transactions on Nuclear Science, Band 36, Nr. 1, Februar 1989, IEEE (New York, NY, US), M.S. Roos et al.: "An instrument control and data analysis program configured for NMR imaging", Seiten 988-992, siehe Abschnitte 1, 3, 5; Abbildung 1
- Patent Abstracts of Japan, Band 9, Nr. 320 (P-413)(2043), 14. Dezember 1985, & JP, A, 60146137

## Beschreibung

Die Erfindung betrifft ein Verfahren zur Erstellung einer Impulssequenz, welche bei einem auf magnetischer Resonanz, z.B. NMR oder ESR basierenden Experiment oder Untersuchungsvorgang eine zeitgerechte Auslösung von Steuersignalen veranlaßt, durch welche physikalische Größen, wie polarisierendes Magnetfeld Hₒ, Trägerfrequenz, Frequenzverteilung, Amplitude und Phasenlage eines anregenden elektromagnetischen HF-Feldes, Erzeugung von Feldgradienten in verschiedenen Koordinatenrichtungen, sowie Empfangszeiten für die aus der HF-Anregung einer Probe oder eines Untersuchungsobjektes resultierenden Antwortsignale nach Abfolge und Zeitverlauf gesteuert werden, wonach diesen physikalischen Größen je ein in einem Rechner verarbeitbarer und speicherbarer, mittels einer Eingabeeinrichtung je nach Art des Experiments änderbarer Satz von Parametern zugeordnet ist, durch deren auf einen gemeinsamen Startzeitpunkt bezogenen, zeitgesteuerten Abruf die Steuersignale erzeugt werden, wobei den Parametersätzen, bei deren Abruf je ein Steuersignal erzeugt wird, je ein auf einem Bildschirm eines für den Dialog des Benutzers mit dem Rechner vorgesehenen Eingabegeräts darstellbares Bildsymbol zugeordnet wird, und wobei eine Zeitmarke ebenfalls auf dem Bildschirm darstellbar ist, sowie eine Anordnung zur Durchführung des Verfahrens.

Aus der EP 0 287 661 A1 ist ein Verfahren zur Erstellung einer Impulssequenz samt einer Anordnung zu seiner Durchführung bekannt. Hiernach werden z.B. die Parameter: Impulsform, -Amplitude, -Dauer sowie die zeitliche Reihenfolge der Impulse der Sequenz über die Eingabetastatur des Rechners eingegeben und dadurch die Sequenz insgesamt programmiert.

Auch wenn das Erstellen der Impulssequenz im Prinzip einfach ist, so erscheint an dem bekannten Verfahren doch nachteilig, daß das Eingeben der zahlreichen Parameter für den Benutzer umständlich ist, weil mit einem hohen Zeitaufwand verbunden.

Mit diesem Nachteil wäre das bekannte Verfahren auch dann behaftet, wenn anstelle einer üblichen Eingabetastatur eine weiter durch die EP 026 8933 A2 bekannte Anordnung zum Eingeben von Daten benutzt würde, bei der dem Benutzer ein Wertevorrat der einzugebenden Parameter in Form diesen einzeln zugeordneter, auf einem Bildschirm dargestellter Skalen angeboten wird, auf denen er durch z. B. mittels einer Maus steuerbare Verschiebung einer Pfeildarstellung oder Drehung einer Zeigerdarstellung einen einzugebenden Parameterwert markieren und/oder -Wertebereich eingrenzen kann. Der mit einem solchermaßen abgewandelten Verfahren für eine komplette Dateneingabe erforderliche Zeitaufwand entspräche jedoch mindestens demjenigen, der bei Anwendung des aus der EP 02 87 661 A1 für sich allein bekannten Verfahrens in Kauf genommen werden muß.

Es ist auch bekannt, Impulssequenzen mittels eines sogenannten Lichtgriffels graphisch zu definieren. Auch dies ist, obwohl es "anschaulicher" und insoweit einfacher erscheint als eine Eingabe digitaler - abstrakter - Werte insoweit umständlich und zeitraubend, als wegen der stark unterschiedlichen Impulsdauern der Steuersignale bei der Erstellung einer solchen Sequenz sehr häufig der Zeitmaßstab, in dem "gezeichnet" wird, geändert werden muß.

Ein Verfahren der eingangs genannten Art ist schließlich aus IEEE Transactions on Biomedical Engineering, Band BME-34, Nr. 12, Dezember 1987; D. Foxvog et al.: "PUPA: A pulse programming assistant for NMR imaging", Seiten 938 - 942 bekannt. Hier erfolgt nach der Auswahl und gegebenenfalls Modifizierung eines Impulses oder einer Impulssequenz, was nur mittels der Eingabetastatur des Rechners möglich ist, eine Anzeige der Impulse bzw. der Impulssequenz auf einem Bildschirm, so daß eine weiter erforderliche Modifizierung anhand der bildlichen Darstellung erleichtert ist.

Aufgabe der Erfindung ist es, ein Verfahren der eingangs genannten Art dahingehend zu verbessern, daß eine experimentgerechte Festlegung einer Sequenz von Steuersignalen für den Benutzer weiter vereinfacht wird, sowie eine Anordnung zur Durchführung dieses - verbesserten - Verfahrens anzugeben.

Diese Aufgabe wird hinsichtlich des Verfahrens durch die kennzeichnenden Merkmale des Patentanspruchs 1 dem Grundprinzip nach und in vorteilhafter Ausnutzung und Ausgestaltung dieses Grundprinzips durch die Merkmale der Ansprüche 2 und 3 gelöst.

Durch die Merkmale der Ansprüche 4 - 6 wird die Darstellung der Sequenz der Steuersignale vereinfacht, zum einen durch eine gemäß Anspruch 4 mögliche Reduktion der Zahl der Zeitachsen, ohne daß hierdurch die Vollständigkeit der Darstellung beeinträchtigt würde, des weiteren durch den gemäß Anspruch 5 vorgesehenen "Verzicht" auf die Darstellung von Parametern, die während des Experiments im wesentlichen konstant bleiben und weiter durch die gemäß Anspruch 6 vorgesehene "Verkürzung" der für die Darstellung benötigten Zeitachsen, welche es erlaubt, die für die Darstellung vorgesehenen Impuls-Verläufe in einem relativ größeren Maßstab darzustellen.

Hinsichtlich der Anordnung zur Durchführung des erfindungsgemäßen Verfahrens wird die eingangs genannte Aufgabe durch die Merkmale des Anspruchs 7 gelöst, wonach das Einfügen von Standardimpulsen in eine zu ändernde Standard-Impulssequenz und/oder die Anordnung von Standard-Impulssymbolen auf Zeitachsen zur Zusammensetzung einer erwünschten Impulssequenz mittels eines Cursors erfolgt. Diese Verschiebung kann mittels der Cursor-Tasten einer üblichen Eingabetasttur erfolgen, was jedoch vielfach umständlich ist.

Demgegenüber wird durch die gemäß Anspruch 8 vorgesehene Art der Bekegungs-Steuerung des Cursors eine weitere Vereinfachung der Anwahl von Sequenzelementen und deren Anordnung auf den hierfür vorgesehenen Zeitachsen der Darstellung erzielt, wobei die Anwendung einer Maus auch eine gleichsam "graphische" Definition von "Sonder"-Impulselementen erlaubt.

In Kombination mit der durch die Merkmale des Anspruchs 9 angegebenen Anordnung von Standardimpulse repräsentierenden Bildsymbolen in einer "vertikalen" Bildsymbol-Spalte wird durch die Merkmale der Ansprüche 10 und 11 auf einfache Weise eine Sicherung gegen eine "Fehlprogrammierung" erreicht.

Eine gemäß Anspruch 12 zur Anwahl von Standard-Impulssequenzen vorgesehene Menü-Leiste des Bildschirmes der Steuereinrichtung kann auch um Optionen ergänzt sein, durch deren Anwahl und Spezifikation für eine Vielzahl von Impulssequenzen erforderliche Maßnahmen definiert werden können, z.B. Wiederholung von Impulssequenzen, Abbruch der Wiederholungen, wenn ein vorgebbares Signal-/Rauschverhältnis erreicht ist, sowie Steuerung inkrementaler Änderungen einzelner Impuls-Parameter in aufeinanderfolgenden Aufnahmezyklen, die durch die jeweilige Sequenz von Steuersignalen gesteuert werden.

Weitere Einzelheiten und Merkmale der Erfindung ergeben sich aus der nachfolgenden Beschreibung eines speziellen Durchführungsbeispiels des erfindungsgemäßen Verfahrens und einer Anordnung zu seiner Durchführung. Es zeigen:
- Fig. 1: ein schematisch vereinfachtes Blockschaltbild einer speziell als NMR-Spektrometer ausgeführten erfindungsgemäßen Anordnung und
- Fig. 2: eine Bildschirm-Darstellung einer speziellen Sequenz von Steuersignalen zur Erläuterung der Funktion des Spektrometers gem. Fig. 1 und eines speziellen Durchführungsbeispiels des erfindungsgemäßen Verfahrens.

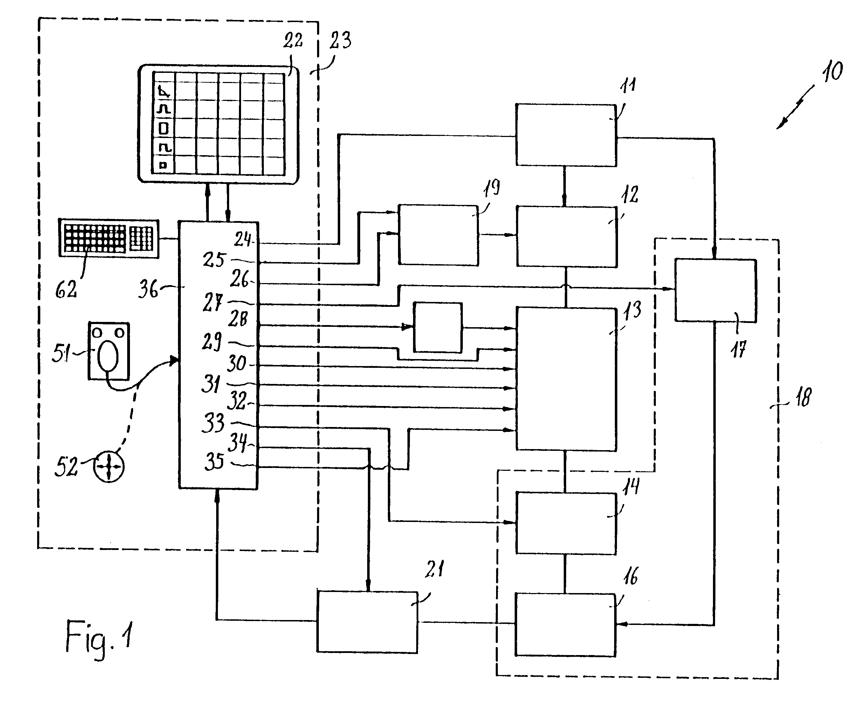

Die in der Fig. 1 als vereinfachtes Blockschaltbild dargestellte, insgesamt mit 10 bezeichnete, Magnetische Resonanzanordnung umfaßt Funktionskomponenten, die mit den noch zu erläuternden Funktionen sowohl bei einem Kernspin-Resonanz(NMR)-Spektrometer, das für wissenschaftliche Experimente gedacht ist, als auch bei einem mit Kernspin-Resonanz arbeitendem NMR-Tomographen vorgesehen sein können, der vorwiegend für medizinische Diagnosezwecke und insoweit für eher routinemäßige Untersuchungen gedacht ist.

Der bei solchen MR-Anordnungen 10 stets vorhandene Magnet, der ein konstantes Magnetfeld hoher Feldstärke und Homogenität erzeugt, dem eine Probe oder - im Falle der Tomographie - Teile eines menschlichen oder tierischen Organismus ausgesetzt werden, ist, der Einfachheit halber, nicht dargestellt. Derartige Magnete sind heute vielfach als Kryomagnete mit supraleitenden Wicklungen ausgebildet, die, einmal mit einem Suprastrom, der ein Magnetfeld erwünschter Feldstärke erzeugt, geladen, über längere Zeit, z.B. ein Jahr, im supraleitenden Zustand gehalten werden, ohne daß anschließend noch steuernd in das insoweit erläuterte Magnetsystem eingegriffen wird.

Dargestellt sind lediglich diejenigen Funktionskomponenten, mit denen experimentelle Größen festgehalten und/oder während eines Experiments oder einer Untersuchung dem Betrage und dem Zeitablauf nach verändert werden. Es sind dies in für sich bekannter elektronisch-schaltungstechnischer Realisierung und funktioneller Kombination zumindest die folgenden Funktionseinheiten:
1. Ein Hochfrequenz (HF)-Sender 11, der ein - kohärentes - elektrisches HF-Ausgangssignal mit einstellbar vorgebbarer Frequenz Ωₒ erzeugt.
2. Ein - steuerbarer - Leistungsverstärker 12, der dem HF-Sender 11 nachgeschaltet ist.
3. Ein bei einem NMR-Spektrometer als "Probenkopf", bei einem NMR-Tomographen als Untersuchungsvolumen bezeichnungsfähiger Bereich 13, innerhalb dessen das Untersuchungsobjekt den für das jeweilige Experiment bzw. der beabsichtigten Untersuchung relevanten physikalischen Einflußgrößen, permanent oder zeitweise, unterwerfbar ist, als welche - beispielsweise - die folgenden genannt seien:
   a) betragsmäßig relativ geringfügige Anhebung oder Absenkung der Feldstärke des von dem Magneten der NMR-Anordnung 10 erzeugten Magnetfeldes, durch dessen Richtung die "longitudinale" Richtung der magnetischen Polarisierung als Z-Richtung in einem kartesischen Koordinatensystem definiert ist.
   b) Betrag, Vorzeichen und Zeitdauer der Wirksamkeit von Feldgradienten G_{z}, Gₓ sowie G_{y} , die in der longitudinalen Z-Richtung sowie in den dazu transversalen X-und Y-Richtungen erzeugbar sind.
   c) Ein erstes, mittels einer von dem Leistungsverstärker 12 gespeister, nicht dargestellter Senderspule einkoppelbares HF-Feld zur resonanten Anregung einer Quermagnetisierung in einem erwünschten Frequenzbereich.
   d) Ein zweites, ebenfalls transversales HF-Feld, durch das eine Sättigung eines resonant anregbaren Magnetisierungszustandes in einem weiteren Frequenzbereich erzielbar ist, um dadurch eine Entkopplung interessierender magnetischer Übergänge von störenden Übergängen zu erzielen.
4. Eine, eine nicht dargestellte Empfängerspule, einen - steuerbaren- Vorverstärker 14 und einen diesem nachgeschalteten phasenempfindlichen Detektor 16 und einen steuerbaren Phasenschieber 17, über den dem phasenempfindlichen Detektor 16 als Referenzsignal das HF-Ausgangssignal des HF-Senders 11 zugeleitet ist, umfassende, insgesamt mit 18 bezeichnete Empfänger-Einrichtung, welche, z.B. nach Beendigung einer Anregung der Quermagnetisierung im Probenkopf 13 für deren Änderung - Zerfall - charakteristische elektrische Ausgangssignale erzeugt, aus deren nach bekannten Kriterien erfolgender Verarbeitung und Auswertung die aus dem Experiment bzw. der Untersuchung ermittelbaren Informationen gewonnen werden.
5. Ein auf den Leistungsverstärker 12 wirkender Puls-Modulator 19, mittels dessen die Amplituden des Ausgangssignals des mit der Trägerfrequenz Ωₒ des HF-Senders 11 angesteuerten Leistungsverstärkers 12 mit einem in der Zeit-Domäne vorgegebenen "rechteckigen" oder glatt gekrümmten, z.B. einer Gauss-Kurve entsprechenden "glockenförmigen" Verlauf modulierbar sind.
   Durch diese Impulsmodulation des HF-Ausgangssignals des Leistungsverstärkers 12 wird, in der Frequenz-Domäne gesehen, die Energie des anregenden HF-Feldes "beidseits" der Trägerfrequenz Ωₒ auf eine Bandbreite verteilt, die um so größer ist, je kürzer die Dauer der Modulationsimpulse ist, wobei die Amplitudenverteilung innerhalb dieser Bandbreite gemäß dem Fourier-Theorem durch die in der Zeitdomäne vorgegebene Form der Modulationsimpulse bestimmt, bzw., wie für sich bekannt, bestimmbar ist (DE-PS 24 14 551).
6. Einen Rechner 21, der eine Fourier-Transformation des Ausgangssignals des phasenempfindlichen Detektors 16 ausführt und eine Ausgabe erzeugt, die als Frequenzspektrum der angeregten Resonanzprozesse bildlich, z.B. mittels eines Monitors 22 darstellbar oder auf andere geeignete Weise, z.B. als Ausdruck dokumentierbar ist.
7. Eine insgesamt mit 23 bezeichnete elektronische Steuereinrichtung, welche in programmierbarer Sequenz an einer Mehrzahl von den vorstehend erläuterten Funktionseinheiten 11, 12, 13, 18, 19 und 21 einzeln zugeordneten Ausgängen Steuersignale abgibt, durch welche diese Funktionseinheiten in der durch die Impulssequenz bestimmten zeitlichen Folge und Dauer zur Einstellung der für den jeweiligen Typ von NMR-Experiment bzw. -Untersuchung nach Qualität und zeitlicher Korrelation erforderlichen physikalischen Größen, als welche auch die Empfangszeitspanne der Empfänger-Einrichtung 18 sowie die Aktivierungszeit des Rechners 21 anzusehen sind, aktiviert werden.

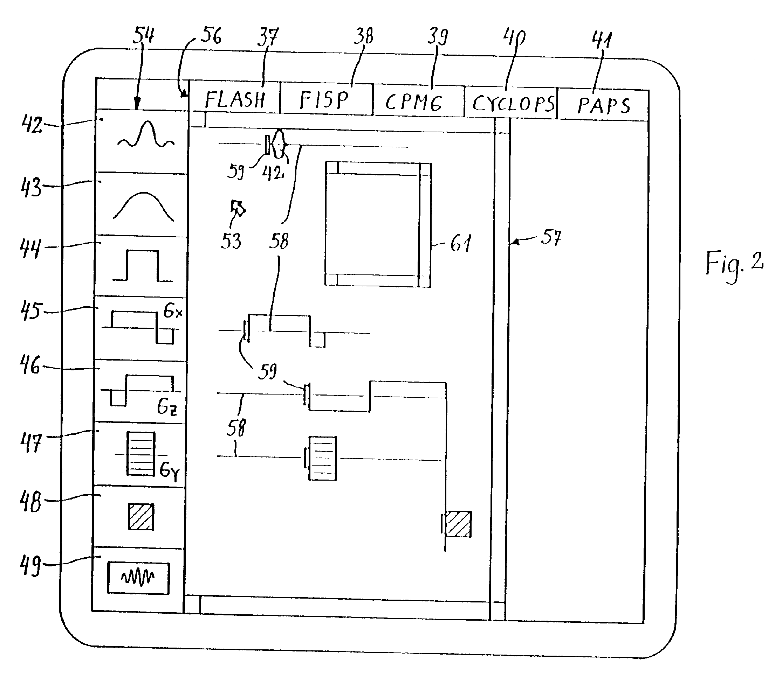

Zur Erläuterung der elektronischen Steuereinrichtung 23 sei nunmehr auch auf die diesbezüglichen Einzelheiten der Figur 2 verwiesen, anhand derer auch eine typische Verfahrensweise geschildert wird, die eine einfache Programmierung der an den Ausgängen 24 bis 35 der Steuereinrichtung 23 abgegebenen Impulssequenzen ermöglicht.

Es wird angenommen, daß es ausreicht, die Steuereinrichtung 23 anhand ihrer Funktionen zu erläutern, deren Realisierung einem einschlägig vorgebildeten Fachmann bei Kenntnis des Zweckes der Steuereinrichtung 23 mit gängigen Mitteln der elektronischen Schaltungstechnik möglich ist.

Die Steuereinrichtung 23 umfaßt einen programmierbaren Rechner 36 mit einem Speicher, in welchem für verschiedenartige Impuls-NMR-Experimente geeignete Standard-Impulssequenzen 37 bis 41 gespeichert sind, welche über ein durch die Ausgänge 24 bis 35 des Rechners 36 respräsentiertes Ausgabewerk in die für die Ansteuerung der Funktionseinheiten 11,12,13,18 und 19 sowie 21 der NMR-Anordnung erforderlichen Steuer-(Spannungs-)Signale umsetzbar sind. Diese Standardsequenzen sind in der Regel Unter-Kombinationen eines Satzes von Standard-Impulsen 42 bis 49 sowie Folgen solcher Impulse, aus denen die Sequenzen gleichsam "zusammengesetzt" sind. Die für ein bestimmtes NMR-Experiment oder auch eine tomographische Untersuchung zum Einsatz gelangende Impulssequenz bedarf im allgemeinen einer Experiment-spezi- fischen Festlegung der charakteristischen Parameter ihrer Standardimpulse , z.B. nach Impulsform, Impulshöhe und Impulsdauer, Veränderung eines oder mehrerer dieser Parameter im Zuge aufeinander folgender Auslösungen der jeweiligen Impulssequenz, u.a.m. und insoweit einer eigenen "Programmierung".

Der diesbezüglich erforderliche Dialog des Benutzers mit dem Rechner erfolgt in der aus der Technik der PC (Personal-Computer) bekannten Weise mittels einer Maus 51 oder eines Joysticks 52, mittels dessen auf dem Bildschirm 22 ein Cursor 53 verschiebbar ist, mittels dessen durch Anfahren von Bildsymbolen, die den einzelnen Standardimpulsen zugeordnet sind, diese für die Eingabe oder Änderung ihrer charakteristischen Parameter auswählbar sind. Die den Standardimpulsen 42 bis 49 zugeordneten Bildsymbole für die nachfolgend dieselben Bezugszeichen verwendet werden wie für die Standardimpulse 42 bis 49, werden gemäß der Darstellung der Figur 2 am linken Rand des Bildschirmes 23 in einer insgesamt mit 54 bezeichneten Bildsymbol-Spalte dargestellt.

Verschiedenen Unterkombinationen von Standardimpulsen 42 bis 49 entsprechende Standardsequenzen 37 bis 41 sind in einer entlang des oberen Bildschirmrandes verlaufenden, insgesamt mit 56 bezeichneten Menüleiste durch ihre üblichen Kurzbezeichnungen wiedergegeben.

Als Beispiele für solche Standard-Impulse sind angegeben:

Die Standardsequenz 37 - "FLASH" (Fast Low Angle Shot).

Die Standardsequenz 38 - "FISP" (Fast Imaging with Steady Precession).

Die Standardsequenz 39 - "CPMG" (Carr-Purcell-Meiboom-Gill-Sequenz).

Die Standardsequenz 40 - "CYCLOPS" (quadrature phase cycling) und
die Standardimpulssequenz 41 - "PAPS" (Phase Alternating Pulse Sequence).

Es versteht sich daß die in der Bildsymbol-Spalte 54 und in der Menü-Leiste 56 der Bildschirmdarstellung gemäß Fig. 2 wiedergegebenen Bildsymbole 42 bis 49 bzw. Kurzbezeichnungen von Standard-Impulssequenzen 37 bis 41 lediglich beispielhaft zu verstehen sind und keineswegs abschließende "Aufzählungen" der möglichen Bildsymbole bzw. Standard-Impulssequenzen darstellen.

Von den in der Menü-Leiste 56 angeführten Standard-Impulssequenzen 37 bis 41 sind die ersten zwei - FLASH und FISP - solche der Bildgebung in der NMR-Tomographie, während die drei letztgenannten Standardimpulssequenzen für die NMR-Impuls-Fourier-Spektroskopie sind.

In einer typischen Verfahrensweise zur Programmierung der NMR-Anordnung 10 für eine tomographische Untersuchung, z.B. nach dem FLASH-Verfahren kann wie folgt vorgegangen werden:

Durch Anfahren des dieser Standard-Impulssequenz 37 zugeordneten Feldes der Menü-Leiste 56 mit dem Zeiger 53 der Maus 51 und Anklicken dieses Feldes 37 wird ein insgesamt mit 57 bezeichnetes Fenster auf dem Bildschirm 22 geöffnet, das eine graphische Darstellung der bei diesem Verfahren benutzten Steuersignale darbietet. Diese Steuersignale sind innerhalb des Fensters 57 in der den Bildsymbolen 42 bis 49 entsprechenden Darstellung wiedergegeben. Sie sind dabei über "parallelen" Zeitachsen 58 wiedergegeben, die den jeweils ausgenutzen Ausgängen des Rechners 36 der Steuereinrichtung 23 zugeordnet sind.

Es sind dies, gemäß der Darstellung der Figur 2 von oben nach unten gesehen, der Ausgang 25 für das Ansteuersignal des Pulsmodulators 19, der Ausgang 31 für den Schicht-Auswahl-Gradienten Gₓ, der Ausgang 30 für den Lesegradienten G_{z}, der Ausgang 32 für den Phasencodiergradienten G_{y}, der Ausgang 35 für den Spoiler-Gradienten 48 und der Ausgang 33 für das Akquisitionsfenster 49.

Bei der Darstellung der Impulssequenz 37 werden Zeitachsen 58 und an diese "angeheftete", die einzelnen Impulse repräsentierende Bildsymbole 42 und 45 bis 49 - der Übersichtlichkeit halber - nur insoweit dargestellt, als es für die Programmierung der zeitlichen Abfolge der einzelnen Impulse erforderlich ist, was durch Verschieben der Bildsymbole 42 und 45 bis 49 entlang ihrer Zeitachsen 58 und Anheftung an diese durch Setzen von Zeitmarken 59 erfolgen kann, wobei es sich natürlich versteht, daß in der Darstellung auf den Zeitachsen 58 übereinander angeordnete Zeitmarken 59 gleiche Zeltpunkte repräsentieren.

An weiteren Ausgängen 24, sowie 26 bis 29 und 34 des Rechners 36 erforderlichenfalls abgegebene Ausgangssignale und deren Zeitverlauf können in einem oder mehreren dem Gesamtdarstellungsfenster 57 hierarchisch untergeordneten Fenster(n) 61 darstellbar sein.

Erforderlichenfalls können in dem Unterfenster 61 weitere Fenster geöffnet werden, in denen durch graphische Symbole und/oder Datenangaben Eigenschaften des jeweiligen Steuersignals darstellbar sind. Dabei kann zeitweise durch ein solches Unterfenster 61 die gesamte Bildschirmfläche belegt sein, je nachdem, wie komplex der Satz von Parametern ist, durch den das jeweilige Steuersignal spezifiziert werden muß.

Eine Eingabe oder Änderung der einen (Standard-)Impuls der Pulssequenz charakterisierenden Parameter erfolgt innerhalb desjenigen Fensters 57 oder 61, in welchem dieser Parameter auch abrufbar ist.

Die Eingabe oder Änderung von Parametern kann graphisch und/oder numerisch erfolgen, letzteres durch Eingabe der numerischen Daten über die Tastatur 62 des Rechners 36.

Die diesbezügliche "Programmierung" des Anregungsimpulses 42 der Impulssequenz 37 erfolgt durch Anklicken des Impulses 42 auf seiner Zeitachse 58 oder durch Anklicken des Typ-gleichen Bildsymbols 42 in der Bildsymbol-Spalte 54, worauf das diesbezügliche Bildsymbol-Unterfenster 61 geöffnet wird, in welchem Felder für die Eingabe seiner charakteristischen Daten vorgesehen sind, nämlich ein Feld für
1. Impulshöhe,
2. Impulsbreite bzw. -dauer,
3. Zeitpunkt des Einsetzens oder Zeitverschiebung desselben gegen eine relevante Zeitmarke 59,
4. Trägerfrequenz Ωₒ der Anregungs-HF sowie
5. Pulswinkel α, um den der Anregungsimpuls die Magnetisierung "dreht",
6. Phasenlage des Impulses, bezogen auf die maßgebliche Referenzfrequenz.

Andere Eigenschaften eines Anregungsimpulses 42, deren programmierende Bezeichnung bzw. Eingabe für weitere NMR-Experimente- und/oder Untersuchungen von Bedeutung sein können, sind der funktionelle Zweck, z.B. zur Selektion einer chemischen Verschiebung oder einer Erstellung eines Darstellungsbereiches sowie die Frequenz- und Amplitudenverteilung des HF-Anregungsspektrums bestimmende Eigenschaften wie Impulsform, z.B. Gauss-Form 43 oder Rechteck-Form 44 und insbesondere in Kombination mit letzterer Impulshöhe und Impulsbreite zur Definition der Eigenschaft "weich" oder "hart".

Auf analoge Weise können die Gradientenimpulse 45, 46 und 47 graphisch und/oder durch charakteristische numerische Daten dargestellt und durch deren Übernahme oder Änderung programmiert werden. Hierbei ist von besonderem Interesse auch das Einblenden der Zeitfunktion des Anstieges des Gradientenstromes mit der Möglichkeit, die Auswirkung der Parameter-Änderungen auf der Grafik zu verfolgen. Bei einem Anklicken des Akquisitions-Fenster-Impulses 49 werden in dem diesem zugeordneten Fenster 61 sämtliche Daten der Signalaufnahme wiedergegeben wie Beginn und Ende der Signalaufnahme, Zeitparameter der Umschaltung von Senden auf Empfangen, die Empfangskanäle, die Empfängerphase, Daten der Filterung, der spektralen Bandbreite, sowie Anzahl und Abstand der Digitalisierungspunkte für die empfangenen Signale.

Sequenzen von Steuersignalen können aber nicht nur durch Eingabe oder Änderung charakteristischer Parameter für ihrem Grundtyp nach in der Steuereinrichtung 23 schon "angebotene" Standardsequenzen 37 bis 41 programmiert werden, sondern können auch durch Kopieren der einzelnen Bildsymbole 42 bis 49 auf die Zeitachse 58 in geeigneter Anzahl und Kombination erstellt werden, wobei die Festlegung der jeweils charakteristischen Parameter wieder in den zugeordneten Fenstern 61 und ggf. Unterfenstern erfolgt, wie vorstehend schon erläutert. Desgleichen können aus im Angebot vorhandenen Standard-Sequenzen 37 bis 41 Teilsequenzen herauskopiert und in eine bestehende Sequenz eingefügt werden und/oder in eine solche Standardsequenz weitere in der Bildsymbol-Spalte 54 angebotene Impulse eingefügt und an den jeweils geeigneten Zeitmarken an die Zeitachsen 58 angeheftet werden. Hierbei können Standard-Sequenzen oder -Teilsequenzen auch "verkurzt" dargestellt werden, d.h. im wesentlichen durch ein Symbol, das erst durch Anklicken seinen konkreten Inhalt zeigt. Soweit ein Impuls nicht im Angebot vorhanden ist, kann dieser graphisch und/oder durch Eingabe seiner numerischen Daten definiert und als für sich abrufbare Einheit gespeichert werden.

Eigenschaften einer Sequenz von Steuersignalen, wie z.B. deren Wiederholung, die nicht über Bildsymbole und diesen zugeordnete Fenster vereinbart werden, können an einer separaten, nicht dargestellten weiteren Menü-Leiste "angeklickt" und durch Eingabe entsprechender Daten auf diesen zugeordneten Fensterfeldern quantifiziert werden.

Bei Sequenzen von Steuersignalen, die sich quasi-periodisch wiederholen, derart, daß ein oder einige Parameter ihrer Impulse geändert werden, wird die Anzahl der - zur Erzielung eines bestimmten Signal-/Rausch-Verhältnisses erforderlichen - periodischen Wiederholungen fest oder über eine Beobachtung der Verbesserung des Signal-/Rausch-Verhältnisses am Monitor bedarfsgerecht festgelegt. Das Bildsymbol derjenigen Größe, die verändert wird, wird dabei zweckmäßigerweise farbig oder durch seine Negativdarstellung gekennzeichnet. In einem der Veränderung zugeordneten Fenster kann z.B. ein Phasenzyklus oder das Inkrement eines Gradienten, der sich im Verlauf einer Gesamt-Untersuchung ändern soll, festgelegt werden.

Zweckmäßig ist es auch, Impulse, welche extern getriggert starten, farbig oder durch Negativdarstellung hervorzuheben. Innerhalb eines zur Festlegung der Parameter solcher Impulse vorgesehenen Fensters wird spezifiziert, daß die Verschiebung bezüglich einer Referenz-Zeitmarke (Trigger-) variabel ist.

Für eine kompakte Darstellung einer Sequenz von Steuersignalen ist es zweckmäßig, die Zeitachsen in Zeitintervallen, in denen "nichts geschieht", zu verkürzen. Das solchermaßen aus einer Zeitachse "herausgenommene Intervall" kann durch ein kleines Fenster mit Angabe der Intervalldauer charakterisiert werden, wobei auch diese Intervalldauer durch Anklicken des Fensters und Eingeben der Intervalldauer mittels der Tastatur 62 veränderbar ist.

Der Rechner 36 verändert entweder on-line die Programmierung der Steuereinrichtung 23 oder beim Schließen eines Fensters 57 bzw. 61 oder erst nach Abschluß der Erstellung der Gesamtsequenz. Hierbei wird überprüft, ob die Sequenz durch die vorhandene Hardware realisierbar ist, oder ob sie aus dem Rahmen des Üblichen fällt oder gar mit der Gefahr einer Beschädigung eines Teils der Anordnungs 10 verknüpft ist. Im letztgenannten Fall wird durch den Rechner eine Warnung abgegeben und u.U. die Weigerung, die Sequenz umzusetzen.

Zweckmäßig ist es, wenn die Impulssequenz zusammen mit dem Meßfile dokumentiert wird, so daß auch nachträglich die mit einem bestimmten Meßergebnis verknüpfte Sequenz eindeutig und anschaulich rekonstruiert werden kann. Darüber hinaus ist vorgesehen, daß eine solchermaßen erstellte und als vorteilhaft erkannte Impulssequenz komplett abgespeichert und dadurch dem Vorrat der Standard-Impulssequenzen" zugeschlagen wird.

## Patentansprüche

1. Verfahren zur Erstellung einer Impulssequenz, welche bei einem auf magnetischer Resonanz, z.B. NMR oder ESR basierenden Experiment oder Untersuchungsvorgang eine zeitgerechte Auslösung von Steuersignalen veranlaßt, durch welche physikalische Größen, wie polarisierendes Magnetfeld Hₒ, Trägerfrequenz, Frequenzverteilung, Amplitude und Phasenlage eines anregenden elektromagnetischen HF-Feldes, Erzeugung von Feldgradienten in verschiedenen Koordinatenrichtungen, sowie Empfangszeiten für die aus der HF-Anregung einer Probe oder eines Untersuchungsobjektes resultierenden Antwortsignale nach Abfolge und Zeitverlauf gesteuert werden, wonach diesen physikalischen Größen je ein in einem Rechner verarbeitbarer und speicherbarer, mittels einer Eingabeeinrichtung je nach Art des Experiments änderbarer Satz von Parametern zugeordnet ist, durch deren auf einen gemeinsamen Startzeitpunkt bezogenen, zeitgesteuerten Abruf die Steuersignale erzeugt werden, wobei den Parametersätzen, bei deren Abruf je ein Steuersignal erzeugt wird, je ein auf einem Bildschirm (22) eines für den Dialog des Benutzers mit dem Rechner (36) vorgesehenen Eingabegeräts darstellbares Bildsymbol (42 bis 49) zugeordnet wird, und wobei eine Zeitmarke (59) ebenfalls auf dem Bildschirm (22) darstellbar ist,
dadurch gekennzeichnet, daß der Zeitpunkt, zu dem der durch dieses Bildsymbol repräsentierte Parametersatz aufgerufen wird, der die Erzeugung des der jeweiligen physikalischen Größe zugeordneten Steuersignals veranlaßt, durch Anheftung des Bildsymbols (42 bis 49) an die auf dem Bildschirm (22) auf einer Zeitachse (58) dargestellte Zeitmarke (59) definiert wird, und daß die Eingabe und/oder Änderung der die Steuersignale erzeugenden Parametersätze durch Aufrufen mindestens eines dem jeweiligen Bildsymbol zugeordneten Fensters (57 bzw. 61) und Einschreiben der Daten in die für jeden der einzelnen Parameter vorgesehenen Fensterfelder erfolgt.

2. Verfahren nach Anspruch 1,
dadurch gekennzeichnet, daß die Erstellung der Impulssequenz durch Änderung abrufbarer und auf dem Bildschirm (22) darstellbarer Standard-Impulssequenzen (37 bis 41) erfolgt.

3. Verfahren nach Anspruch 1 oder Anspruch 2,
dadurch gekennzeichnet, daß die Erstellung der Impulssequenz durch Zusammensetzung aus Standardimpulsen und/oder durch Einfügen solcher Standardimpulse in eine änderbar vorgegebene Standard-Impulssequenz erfolgt.

4. Verfahren nach einem der Ansprüche 1 bis 3,
dadurch gekennzeichnet, daß Impulsen, die über einen gemeinsamen Ausgangskanal je eine der physikalischen Größen, unter denen das Experiment oder die Untersuchung erfolgt, steuern, in der Darstellung eine gemeinsame Zeitachse (58) zugeordnet wird.

5. Verfahren nach einem der Ansprüche 1 bis 4,
dadurch gekennzeichnet, daß in der Gesamtdarstellung der Impulssequenz nur diejenigen Impulse dargestellt werden, durch deren zeitliche Folge der Ablauf des Experiments oder der Untersuchung bestimmt wird.

6. Verfahren nach einem der Ansprüche 1 bis 5,
dadurch gekennzeichnet, daß in der Darstellung der gesamten Impulssequenz Zeitintervalle, innerhalb derer an sämtlichen Ausgangskanälen konstanter Signalpegel herrscht, durch Zeitintervall-Darstellungen ersetzt werden, derart, daß die Reihenfolge der Einzelimpulse erhalten bleibt, wobei diesbezügliche Verkürzungen durch Fenstersymbole markiert sind, deren Inhalt - die Zeitdauer der nicht dargestellten Zeitspanne - abrufbar ist.

7. Anordnung zur Durchführung des Verfahrens nach einem der Ansprüche 1 bis 6, mit einer elektronischen Steuereinrichtung, welche aus gespeicherten Datensätzen mittels eines programmierbaren Rechners Steuersignale erzeugt, durch welche die Funktionskomponenten der Anordnung - Sender, Magnet, Gradientensystem und Empfänger-Einrichtung - in dem Zweck eines Experiments oder einer Routine-Untersuchung entsprechender Folge zur Einstellung der physikalischen Größen ansteuerbar sind, wobei für den Dialog zwischen dem Rechner (36) mit Speicher, einerseits, und dem Benutzer, andererseits, eine Abruf- und Eingabe-Einrichtung vorgesehen ist, die einen Bildschirm (22) umfaßt, auf dem Bildsymbole (42 bis 49), welche einen Vorrat von Standard-Impulsen und/oder -Sequenzen repräsentieren, auf Zeitachsen (58), die in der Bildschirmdarstellung Ausgangs- bzw. Steuerkanäle repräsentieren, darstellbar sind, und wobei die Anordnung ein Eingabegerät (62) umfaßt, mittels dessen die Impulse hinsichtlich ihrer charakteristischen Parameter - z. B. Impulshöhe, -breite, Anstiegs- und Abfall-Zeitverlauf - spezifizierbar sind,
dadurch gekennzeichnet, daß
durch Übertragung der auf dem Bildschirm in einem Symbolfeld (54) darstellbaren Bildsymbole (42 bis 49) auf die besagten Zeitachsen (58) und/oder Verschiebung solcher Symbole entlang der Zeitachsen die zeitliche Reihenfolge festlegbar ist, mit der die durch die Bildsymbole (42 bis 49) repräsentierten Steuerimpulse nach einem Startbefehl erzeugt und ggf. wiederholt werden, und daß die Anordnung ein Steuergerät umfaßt, mit dem durch Verschiebung eines Cursors (53) die einzelnen Bildsymbole (42 bis 49) auswählbar und auf den Zeitachsen (58) anordenbar sind.

8. Anordnung nach Anspruch 7,
dadurch gekennzeichnet, daß als Steuergerät für die Bewegung des Cursors (53) eine Maus (51) oder ein Joystick (52) vorgesehen ist, mittels derer bzw. dessen durch "Anklicken" des Symbolfeldes oder des auf der Zeitachse (58) bereits angeordneten Impulssymbols ein Fenster (61) geöffnet wird, das für die Eingabe oder Änderung bzw. Wiedergabe der charakteristischen Impulsparameter ebenfalls "anklickbare" Felder enthält, sowie Befehlsfelder, durch deren "Anklicken" die Programmierung des Rechners (36) und die Speicherung der Fensterdaten steuerbar ist.

9. Anordnung nach Anspruch 7 oder Anspruch 8,
dadurch gekennzeichnet, daß das Symbolfeld des Bildschirmes (22) als Bildsymbol-Spalte (54) darstellbar ist, die - vorzugsweise - entlang eines vertikalen Randbereiches des Bildschirmes (22) angeordnet ist, auf dem die Zeitachsen (58), innerhalb der von dem einzelnen Bildsymbol-Feld (42 bis 49) eingenommenen - vertikalen - Streifenbreite, horizontal verlaufend dargestellt sind.

10. Anordnung nach Anspruch 9,
dadurch gekennzeichnet, daß ein einen Standardimpuls repräsentierendes Bildsymbol nur auf vorgegebene Zeitachsen anordenbar und entlang dieser verschiebbar ist.

11. Anordnung nach Anspruch 10,
dadurch gekennzeichnet, daß ein einen Standardimpuls repräsentierendes Bildsymbol nur entlang seiner benachbarten Zeitachse (58) anordenbar und/oder auf dieser verschiebbar ist.

12. Anordnung nach einem der Ansprüche 7 bis 11,
dadurch gekennzeichnet, daß eine Menü-Leiste (56) darstellbar ist, welche einzelnen Standard-Impulssequenzen (37 bis 41) zugeordnete Felder hat, durch deren "Anklicken" eine Darstellung der jeweiligen Impulssequenz (37 bis 41) auf dem Bildschirm (22) abrufbar ist.

## Claims

1. Method to generate a pulse sequence which, in an experiment or investigation based on magnetic resonance, e.g. NMR or ESR, effects at predetermined times the triggering of control signals by which physical quantities such as polarizing magnetic field H₀, carrier frequency, frequency distribution, amplitude and relative phase of an exciting electromagnetic RF field, generation of field gradients in various coordinate directions, as well as detection times for response signals resulting from the RF excitation of a sample or investigated object are controlled according to their sequence and time profiles, whereby sets of parameters are allocated to said physical quantities which can be processed and stored in a computer and changed depending on the type of the experiment by means of input means, whereby with respect to a common starting point in time, the chronologically controlled retrieval of the parameter sets generating the control signals, whereby the parameter sets, the retrieval of which each generating a control signal, are each assigned to one image symbol (42 to 49) which is displayable on a screen (22) of an input device provided for dialog between the user and the computer (36), and whereby a time mark (59) can also be displayed on said screen (22)
characterized in that
the point in time at which the parameter set represented by this image symbol is retrieved, the parameter set generating the corresponding control signals allocated to the physical quantity, is defined by attaching the image symbol (42 to 49) to the time mark (59), on a time axis (58), represented on the screen (22), and that the input and/or change of the parameter sets generating the control signals is effected by opening at least one window (57 or 61) allocated to the respective image symbol and entering of the data into the window fields provided for each particular parameter.

2. Method according to claim 1, characterized in that the generation of the pulse sequence is effected by changing standard pulse sequences (37 to 41) which are retrievable and can be displayed on the screen (22).

3. Method according to claim 1 or claim 2, characterized in that the generation of the pulse sequence is effected by combining standard pulses and/or by entering such standard pulses into a predefined changeable standard pulse sequence.

4. Method according to claim 1 to 3, characterized in that pulses which, via a common output channel, each control one of the physical quantities by means of which the experiment or the investigation is effected, are assigned to the display of a common time axis (58).

5. Method according to claims 1 to 4, characterized in that in the overall display of the pulse sequence only those pulses are represented whose time sequence determines the course of the experiment or the investigation.

6. Method according to claims 1 to 5, characterized in that in a display of the entire pulse sequence, time intervals where the signal levels of all output channels are constant are replaced by representations of time intervals such that the sequence of individual pulses is preserved, whereby respective shortenings are marked by window symbols, whose content - the length of the not represented time period - may be recalled.

7. Apparatus for performing the method according to one of claims 1 to 6, with electronic control means which generate control signals from stored data sets by means of a programmable computer, by which control signals functional components of the apparatus - transmitter, magnet, gradient system, and receiver means - can be controlled in a sequence adapted to the purpose of an experiment or a routine investigation in order to adjust the physical quantities, whereby for the dialogue between, on the one hand the computer (36) with its storage means, and, on the other hand the user, retrieval and input means are provided comprising a screen (22) where image symbols (42 to 49), representing a supply of standard pulses and/or sequences can be displayed on time axes (58) representing on the screen display output or control channels, respectively, and whereby the apparatus includes an input device (62), by means of which the pulses can be specified with regard to their characteristic parameters such as pulse width and height and rise and fall time dependences, characterized in that the time sequence with which the control pulses represented by the image symbols (42 to 49) are, following a start-command, generated or repeated can be determined by transfer of the image symbols (42 to 49), which can be displayed on the screen in a symbol field (54), onto said time axes (58), and/or by shifting such symbols along the time axes, whereby the apparatus comprises control means to shift a cursor (53) to select individual image symbols (42 to 49) and to place them on the time axes (58).

8. Apparatus according to claim 7 characterized by a mouse (51) or a joy stick (52) as control means for moving the cursor (53) to open a window (61) by "clicking on" the symbol field or an image symbol already placed on a time axis (58), which window contains fields which can also "be clicked" on to inspect, change, or enter the characteristic pulse parameters as well as command fields which control the programming of computer (36) and the storing of the window parameters if "clicked" on.

9. Apparatus according to claim 7 or claim 8 characterized by a screen (22) symbol field which can be displayed as an image symbol column (54) preferentially located along a vertical margin of screen (22) upon which the horizontal time axes (58) can be displayed within the vertical stripe width occupied by the individual image symbol field (42 to 49).

10. Apparatus according to claim 9 characterized in that an image symbol representing a standard pulse can only be placed onto and shifted along predetermined time axes.

11. Apparatus according to claim 10 characterized in that an image symbol representing a standard pulse can only be placed onto and/or shifted along its adjacent time axis (58).

12. Apparatus according to one of the claims 7 through 11 characterized in that a menu strip (56) can be displayed which has fields assigned to individual standard-pulse sequences (37 to 41), the "clicking on" of which fields facilitating the recall of a display of the corresponding pulse sequence (37 to 41) on the screen (22).

## Revendications

1. Procédé pour former une séquence d'impulsions qui, lors d'une expérience ou processus d'étude à base de résonance magnétique, par exemple de RMN ou de RSE, provoque un déclenchement en temps voulu de signaux de commande par lesquels des grandeurs physiques comme le champ magnétique polarisant Ho, la fréquence porteuse, la répartition de fréquences, l'amplitude et la relation des phases d'un champ électromagnétique HF-excitateur, la production de gradients de champ dans différentes directions de coordonnées, ainsi que les temps de réception pour les signaux de réponse résultants de l'excitation-HF d'un échantillon ou d'un objet d'étude sont commandées selon la progression et l'évolution temporelle, selon lequel est associée à chacune de ces grandeurs physiques une série de paramètres qui peuvent être traités et stockés dans un calculateur et qui peuvent être modifiés selon le type de l'expérience au moyen d'un dispositif d'entrée, dont l'interrogation rapportée à un instant de départ commun et commandée temporellement produit les signaux de commande, un symbole vidéo (42 à 49) qui peut être représenté sur un écran (22) d'un appareil d'entrée prévu pour le dialogue de l'utilisateur avec le calculateur (36) étant associé à chacune des séries de paramètres lors de l'interrogation desquelles un signal de commande est produit, et un repère de temps (59) pouvant être représenté également sur l'écran (22), caractérisé en ce que l'instant auquel est interrogée la série de paramètres représentée par ce symbole vidéo, qui provoque la production du signal de commande associé à la grandeur physique correspondante est défini par fixation du symbole vidéo (42 à 49) au repère de temps (59) représenté sur un axe des temps (58) sur l'écran (22) et en ce que l'introduction et/ou la modification des séries de paramètres produisant les signaux de commande est réalisée par appel d'au moins une fenêtre (57 ou 61) associée au symbole vidéo correspondant et inscription des données dans les champs de fenêtres prévus pour chacun des différents paramètres.

2. Procédé selon la revendication 1, caractérisé en ce que la production de la séquence d'impulsions se fait par modification de séquences d'impulsions standards (37 à 41) qui peuvent être interrogées et qui peuvent être représentées sur l'écran (22).

3. Procédé selon la revendication 1 ou la revendication 2, caractérisé en ce que la production de la séquence d'impulsions se fait par assemblage à partir d'impulsions standards et/ou par introduction de telles impulsions standards dans une séquence d'impulsions standard predéfinie de manière modifiable.

4. Procédé selon l'une des revendications 1 à 3, caractérisé en ce que, dans la représentation**,** un axe des temps commun (58) est associé aux impulsions qui commandent par l'intermédiaire d'un canal de sortie commun chacune des grandeurs physiques selon lesquelles se déroule l'expérience ou l'étude.

5. Procédé selon l'une des revendications 1 à 4, caractérisé en ce que, dans la présentation globale de la séquence d'impulsions, seules sont représentées les impulsions par la suite temporelle desquelles est déterminé le déroulement de l'expérience ou de l'étude.

6. Procédé selon l'une des revendications 1 à 5, caractérisé en ce que, dans la représentation de la séquence d'impulsions globale, les intervalles de temps à l'intérieur desquels règne un niveau de signal constant dans tous les canaux de sortie sont remplacés par des représentations d'intervalles de temps de manière que la succession des impulsions individuelles soit conservée, les raccourcissements correspondants étant marqués par des symboles de fenêtres dont le contenu, la durée de la période temporelle non représentée, peut être interrogé.

7. Agencement pour la mise en oeuvre du procédé selon l'une des revendications 1 à 6**,** comportant un dispositif de commande électronique qui, à partir de séries de données mémorisées, produit au moyen d'un calculateur programmable des signaux de commande par lesquels peuvent être commandées les composantes de fonction de l'agencement, émetteur, aimant, système de gradients et dispositif récepteur, dans la succession correspondant à une expérience ou à une étude de routine pour établir les grandeurs physiques, dans lequel il est prévu pour le dialogue entre le calculateur (36) muni d'une mémoire d'une part et l'utilisateur d'autre part, un dispositif d'interrogation et d'entrée qui comporte un écran (22) sur lequel sont représentés des symboles vidéo (42 à 49) qui représentent une réserve d'impulsions standards et/ou de séquences standards sur des axes des temps (58), qui représentent des canaux de sortie ou de commande dans la représentation de l'écran, et l'agencement comportant un appareil d'entrée (62) au moyen duquel les impulsions peuvent être spécifiées en ce qui concerne leurs paramètres caractéristiques, par exemple hauteur d'impulsion, largeur d'impulsion, évolution temporelle de la montée et de la descente, caractérisé en ce que la succession temporelle selon laquelle les impulsions de commande représentées par les symboles vidéo (42 à 49) sont produites après un ordre de départ et éventuellement répétées peut être fixée par transfert des symboles vidéo (42 à 49) qui peuvent être représentés sur l'écran dans un champ de symboles (54) sur lesdits axes des temps (58) et/ou par déplacement de tels symboles le long des axes des temps, et en ce que l'agencement comporte un appareil de commande par lequel les différents symboles vidéo (42 à 49) peuvent être choisis et peuvent être disposés sur les axes des temps (58) par déplacement d'un curseur (53).

8. Agencement selon la revendication 7, caractérisé en ce qu'il est prévu comme appareil de commande pour le déplacement du curseur (53) une souris (51) ou un joystick (52) au moyen de laquelle ou duquel, par "cliquage" du champ de symboles ou du symbole d'impulsion déjà disposé sur l'axe des temps (58), une fenêtre (61) est ouverte qui contient des champs eux aussi "cliquables" pour l'entrée ou la modification ou la reproduction des paramètres d'impulsions caractéristiques, ainsi que des champs d'ordre par le "cliquage" desquels la programmation du calculateur (36) et la mémorisation des données de fenêtres peuvent être commandées.

9. Agencement selon la revendication 7 ou la revendication 8, caractérisé en ce que le champ de symboles de l'écran (22) peur être représenté sous forme d'une zone de symboles vidéo (54) qui est disposée de préférence le long d'un domaine de bordure vertical de l'écran (22) sur lequel les axes des temps (58) sont représentés horizontalement à l'intérieur de la largeur de bande verticale définie par le champ de symboles vidéo individuel (42 à 49).

10. Agencement selon la revendication 9, caractérisé en ce qu'un symbole vidéo représentant une impulsion standard ne peut être disposé et déplacé que sur des axes des temps prédéterminés.

11. Agencement selon la revendication 10, caractérisé en ce qu'un symbole vidéo représentant une impulsion standard ne peut être disposé et/ou déplacé que le long de son axe des temps (58) voisin.

12. Agencement selon l'une des revendications 7 à 11, caractérisé en ce qu'il est possible de représenter une barre des menus (56) qui comporte des champs associés aux différentes séquences d'impulsions standards (37 à 41), champs par le "cliquage" desquels une représentation de la séquence d'impulsions (37 à 41) correspondante sur l'écran (22) peut être appelée.
